# EUROPÄISCHE PATENTANMELDUNG

(11) **EP 0 887 649 A2**
(43) Veröffentlichungstag der Anmeldung: **30.12.1998**
(21) Anmeldenummer: 98110753.5
(22) Anmeldetag: 12.06.1998
(51) Int. Cl.: G01R 31/02

(54) **Verfahren und Schaltungsanordnung zur Überprüfung von Leitungsfehlern in einem Zweidraht-Bus-System**

(30) Priorität: 23.06.1997 DE 19726538
(71) Anmelder: Daimler-Benz Aktiengesellschaft, 70567 Stuttgart (DE)
(72) Erfinder: Fluhrer, Sven, 73035 Göppingen (DE)

(57) **Zusammenfassung**

Die vorliegende Erfindung betrifft ein Verfahren zur Überprüfung von Leitungsfehlern in einem Zweidraht-Bussystem durch Vergleich der Spannungspegel auf den beiden Drähten mit bestimmten Schwellwerten, wobei ein Vergleich mit den Schwellwerten im dominanten und im rezessiven Zustand erfolgt. Weiterhin betrifft die Erfindung eine Schaltungsanordnung zur Durchführung des Verfahren, bei der ein Eingang eines ersten Komparators mit dem einen Draht verbunden ist, wobei ein Eingang eines zweiten Komparators mit dem anderen Draht verbunden ist und wobei die anderen Eingänge des ersten und des zweiten Komparators jeweils mit einer Spannung beaufschlagt werden, die zwischen den beiden Spannungswerten auf den Drähten im dominanten und rezessiven Zustand im Normalbetrieb liegt, wobei weiterhin ein Eingang eines dritten Komparators mit dem einen Draht verbunden ist, wobei ein Eingang eines vierten Komparators mit dem anderen Draht verbunden ist und wobei die anderen Eingänge des dritten und des vierten Komparators jeweils mit einer Spannung beaufschlagt werden, die oberhalb des maximalen Spannungswertes auf den Drähten im dominanten und rezessiven Zustand im Normalbetrieb liegt, wobei die Ausgänge des ersten und des zweiten Komparators einem Subtrahierer zugeführt werden, wobei eine Spannungsanpassung des Pegels des Ausgangssignales erfolgt, wobei das Ausgangssignal des Subtrahierers dem Eingang eines fünften Komparators zugeführt wird und wobei das Ausgangssignal des Subtrahierers weiterhin über eine Diode dem Eingang eines Fensterkomparators zugeführt wird, wobei weiterhin die Ausgänge des dritten und des vierten Komparators mit dem Eingang des Fensterkomparators verbunden sind.

## Beschreibung

Die vorliegende Erfindung betrifft ein Verfahren und eine Schaltungsanordnung zur Überprüfung von Leitungsfehlern einem Zweidraht-Bus-System nach den Oberbegriffen der Patentansprüche 1 und 5, wonach eine Überprüfung von Leitungsfehlem in einem Zweidraht-Bussystem durch einen Vergleich der Spannungspegel auf den beiden Drähten mit bestimmten Schwellwerten erfolgt, wobei der Vergleich mit den Schwellwerten im dominanten und rezessiven Zustand erfolgt.

Es ist bereits ein Verfahren bekannt (DE 42 12 742 A1), nach dem vorzugsweise beide Endstufen zumindest eines Busteilnehmers angesteuert werden. Über zwei Kontrollleitungen werden die sich auf den beiden Drähten des Bus-Systems einstellenden Spannungen überprüft, indem diese beiden Kontrollleitungen über einen A/D-Wandler dem Eingang eines Mikroprozessors zugeführt werden. Weiterhin sind in einer Tabelle Spannungswerte angegeben, die sich bei einer Ansteuerung beider Endstufen auf den beiden Drähten des Zweidraht-Bus-Systems in Abhängigkeit von unterschiedlichen Fehlerfällen einstellen. Derartige Fehlerfälle können beispielsweise in einem Kurzschluß nach Masse, einem Kurzschluß zum Potential der Versorgungsspannung, einem Kurzschluß der beiden Drähte oder auch im Drahtabriß bestehen. Wenn die Spannungswerte auf den beiden Drähten in dem Mikroprozessor erfaßt sind, sollen diese Spannungswerte mit den in der Tabelle angegebenen Werten verglichen werden, um einen möglichen Fehlerfall eindeutig erkennen und zuordnen zu können. Für jeden der beiden Drähte sind dabei acht Spannungswerte angegeben, in Abhängigkeit davon, ob das System fehlerfrei arbeitet oder ob ein Fehlerfall vorliegt, und wenn ein Fehlerfall vorliegt, um welchen Fehlerfall es sich handelt. Die weitere Auswertung gestaltet sich daher durch die Notwendigkeit eines Vergleiches jeder der gemessenen Spannungen mit acht Spannungswerten als vergleichsweise aufwendig. Auch wenn es vorstellbar ist (was allerdings in der genannten Entgegenhaltung nicht im einzelnen beschrieben wurde), daß dies mittels einer Software des Mikroprozessors machbar ist, gestaltet sich dieses Verfahren als vergleichsweise aufwendig.

Aus der DE 195 09 133 A1 ist es weiterhin bekannt, die beiden Signalleitungen des Zweidrahtbussystems Eingängen von Komparatoren zuzuführen. Dabei ist ein Komparator vorgesehen, dessen beiden Eingängen jeweils eine der beiden Signalleitungen zugeführt wird. Mittels dieses Komparators wird die Spannungsdifferenz zwischen den beiden Signalleitungen erfaßt. Weiterhin sind zwei Komparatoren vorhanden, deren einem Eingang jeweils eine der beiden Signalleitungen zugeführt und deren anderem Eingang jeweils eine Bezugsspannung zugeführt wird, die etwa dem Wert V_{cc}/2 entspricht. Aus verschiedenen Kombinationen der Pegel der Ausgänge der Komparatoren im dominanten wie rezessiven Zustand können bestimmte Fehlersituationen wie Kurzschlüsse gegen Masse oder gegen V_{cc} erkannt werden. Weiterhin kann eine Entscheidung getroffen werden, ob es möglich bzw. sinnvoll ist, bei bestimmten Situationen mit einer Eindrahtübertragung mit der fehlerfreien Leitung fortzufahren.

Aufgabe der vorliegenden Erfindung ist es, die Möglichkeiten der Fehlererkennung zu erweitern.

Erfindungsgemäß wird dies durch ein Verfahren nach Anspruch 1 gelöst, wonach die Spannungen auf den beiden Drähten mit jeweils einem Spannungspegel verglichen werden, der oberhalb des maximalen Spannungswertes auf den Drähten im dominanten und rezessiven Zustand im Normalbetrieb liegt.

Dadurch wird beispielsweise die Erkennung eines Kurzschluß eines oder beider Drähte nach der Netz- bzw. Batteriespannung U_{Batt} möglich. Andernfalls war es nur möglich, einen Kurzschluß nach Masse oder nach V_{cc} zu erkennen.

Gegenüber der Vorgehensweise bei der DE 42 12 742 A1 zeigt sich dabei vorteilhaft, daß durch die Überprüfung der Spannungsverhältnisse bei den beiden definierten Zuständen insgesamt weniger Schwellwerte benötigt werden, um die Überprüfung durchzuführen. Außerdem kann die Überprüfung während des normalen Sendebetriebes erfolgen, ohne daß eine besondere Prüfsituation erzeugt werden müßte, wie dies in der DE 42 12 742 A1 beschrieben worden ist.

Mit dem Verfahren nach Anspruch 2 wird eine Dimensionierung angegeben, mit der die Spannungspegel auf den beiden Drähten im einfachsten Fall verglichen werden können, um einen Fehlerfall feststellen zu können. Demnach werden die Spannungen auf den beiden Drähten mit jeweils einem Spannungspegel verglichen, der zwischen den beiden Spannungswerten auf den Drähten im dominanten und rezessiven Zustand im Normalbetrieb liegt.

Bei dem Verfahren nach Anspruch 3 erfolgt - in Kombination mit den beschriebenen Verfahrensschritten oder auch erfindungsgemäß ohne diese Verfahrensschritte - ein Vergleich der Spannungsdifferenz zwischen den Spannungen auf den beiden Drähten im dominanten und rezessiven Zustand mit vorgegebenen Schwellwerten.

Dadurch ist eine weitere Eingrenzung eines eventuellen Fehlers möglich.

Vorteilhaft wird eine weitere Eingrenzung eines eventuellen Fehlers mit dem Verfahren nach Anspruch 4 möglich, nach dem die Spannungsdifferenz zwischen den Spannungen auf den beiden Drähten auf das Überschreiten eines ersten Spannungspegels überwacht wird sowie darauf, ob der Spannungspegel innerhalb eines durch einen zweiten und einen dritten Spannungspegel vorgegebenen Fensters liegt, wobei der erste Spannungspegel über dem zweiten und dem dritten Spannungspegel liegt.

Anspruch 5 beschreibt eine Schaltungsanordnung zur Durchführung eines der vorgenannten Verfahren, wonach ein Eingang eines ersten Komparators mit dem einen Draht verbunden ist, wonach ein Eingang eines zweiten Komparators mit dem anderen Draht verbunden ist und wonach die anderen Eingänge des ersten und des zweiten Komparators jeweils mit einer Spannung beaufschlagt werden, die zwischen den beiden Spannungswerten auf den Drähten im dominanten und rezessiven Zustand im Normalbetrieb liegt, wonach weiterhin ein Eingang eines dritten Komparators mit dem einen Draht verbunden ist, wonach ein Eingang eines vierten Komparators mit dem anderen Draht verbunden ist und wonach die anderen Eingänge des dritten und des vierten Komparators jeweils mit einer Spannung beaufschlagt werden, die oberhalb des maximalen Spannungswertes auf den Drähten im dominanten und rezessiven Zustand im Normalbetrieb liegt, wonach die Ausgänge des ersten und des zweiten Komparators einem Subtrahierer zugeführt werden, wobei eine Spannungsanpassung des Pegels des Ausgangssignales erfolgt, wobei das Ausgangssignal des Subtrahierers dem Eingang eines fünften Komparators zugeführt wird und wobei das Ausgangssignal des Subtrahierers weiterhin über eine Diode dem Eingang eines Fensterkomparators zugeführt wird, wobei weiterhin die Ausgänge des dritten und des vierten Komparators mit dem Eingang des Fensterkomparators verbunden sind.

Mit dieser Schaltungsanordnung können also verschiedene Fehlerfälle unterschieden werden, wobei vorteilhaft gegenüber dem vorbekannten Stand der Technik die Anzahl der Spannungskomparatoren begrenzt ist.

Bei der Weiterbildung der Schaltungsanordnung gemäß Anspruch 6 werden die Ausgänge des ersten, des zweiten und des fünften Komparators sowie des Fensterkomparators ausgewertet, um auf den Zustand der Drähte zu schließen.

Durch die Auswertung der Ausgange der Komparatoren wird es vorteilhaft nicht mehr notwendig, die Erfassung der Spannung mittels eines A/D-Wandlers durchzuführen, was ein Vorteil hinsichtlich der Kosten ist. Weiterhin zeigt sich bei den als Schwellwert einstellbaren Spannungspegeln nach der vorliegenden Erfindung, daß diese Spannungspegel deutlich weiter auseinander liegen als dies bei der Tabelle nach der DE 42 12 742 A1 zur Unterscheidung der einzeln: Fehlerfälle dargelegt ist Ein Unterschied der Spannungspegel in der Größnordnung von einigen 1/10 Volt kann beispielsweise schon durch einen Masseversatz bedingt sein, der aufeiner schlechten Kontaktierung nach Masse resultiert.

Durch die erfindungsgemäße Lösung ist also eine weitergehende Eingrenzung des vorliegenden Fehlerfalles möglich.

Ein Ausführungsbeispiel der Erfindung ist in der Zeichnung dargestellt. Die Figuren zeigen dabei im einzelnen:
- Fig. 1:: die Darstellung eines Zwei-Draht-Bus-Systems mit möglichen Fehlern,
- Fig. 2:: eine Schaltungsanordung zur Durchführung des Verfahrens,
- Fig. 3:: die Signalbetrachtung der einzelnen relevanten Busfehler,
- Fig. 4:: eine Matrix der Kombinationen der TTL-Pegel und
- Fig. 5:: eine auf die Fehlerfälle reduzierte Matrix.

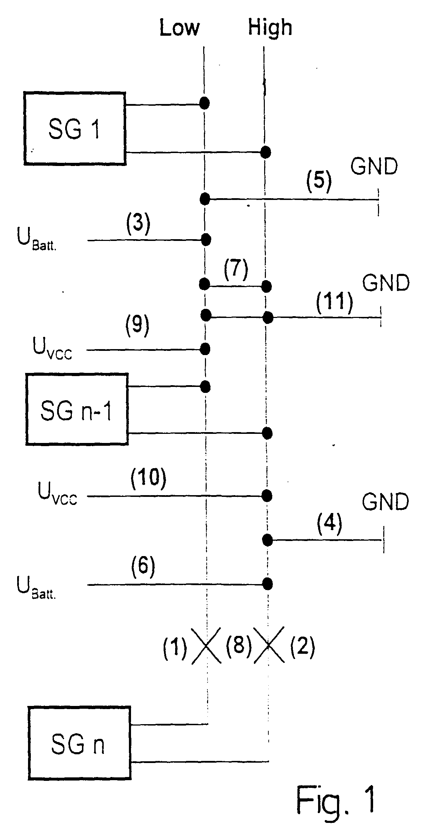

Figur 1 zeigt die Darstellung eines Zwei-Draht-Bus-Systems mit möglichen Fehlern. Die beiden Busdrähte sind mit Low und High bezeichnet. An diese beiden Busdrähte können verschiedene Steuergeräte angeschlossen sein, die über das Bus-System Daten austauschen. In der Darstellung der Figur 1 sind hier beispielhaft die Steuergeräte SG₁, SGₙ₋₁ und SGₙ eingezeichnet.

Weiterhin sind verschiedene Fehlerfälle eingezeichnet, die im folgenden kurz aufgelistet werden sollen:
- Fehler 1:: Drahtabriß des Busdrahtes "Low",
- Fehler 2:: Drahtabriß des Busdrahtes "High",
- Fehler 3:: Kurzschluß des Busdrahtes "Low" zu der Netzspannung bzw. Batteriespannung U_{Batt},
- Fehler 4:: Kurzschluß des Busdrahtes "High" auf Masse,
- Fehler 5:: Kurzschluß des Busdrahtes "Low" auf Masse,
- Fehler 6:: Kurzschluß des Busdrahtes "High" zu der Netzspannung bzw. Batteriespannung U_{Batt},
- Fehler 7:: Kurzschluß der beiden Busdrähte "Low" und "High" gegeneinander,
- Fehler 8:: Drahtabriß der beiden Busdrähte "Low" und "High",
- Fehler 9:: Kurzschluß des Busdrahtes "Low" gegen die Spannung V_{cc},
- Fehler 10:: Kurzschluß des Busdrahtes "High" gegen die Spannung V_{cc},
- Fehler 11:: Kurzschluß der beiden Busdrähte "Low" und High" sowohl gegeneinander als auch gegen Masse.

Im Feldbusbereich CAN werden seit jüngster Zeit fehlertolerante Endstufen (Transceiver bzw. Physical layer) eingesetzt. Diese Endstufen bewerten die Signale auf dem Nachrichtenübertragungsmedium und bereiten Sie gegebenenfalls bei einem Leitungsfehler so auf, daß ein Signal sendender und empfangender Protokollbaustein mit nachgeschaltetem Mikrocontroller keine zusätzliche Fehlerbehandlung durchführen muß und im günstigsten Fall keine Nachricht verloren geht. Die zu behandelnden Busfehler der fehlertoleranten Transceiver sind weitgehend ein Teilbereich aus der CAN-Spezifikation V2.0 ISO/DIS 11519 Part 1 und ISO/DIS 11898 "Bus failure management", jeweils Kapitel 11. Figur 1 zeigt entsprechend der dort gewählten Nomenklatur die bus failures 1 bis 8 unter den entsprechenden Fehlern mit den Nummern 1 bis 8. Weiterhin wurden in dem hier gezeigten Ausführungsbeispiel noch die Fehlerfälle 9, 10 und 11 ergänzt, die im Betrieb ebenfalls auftreten können (beispielsweise bei der Netzmontage oder infolge vom Alterung) und nach Möglichkeit erkannt werden sollen.

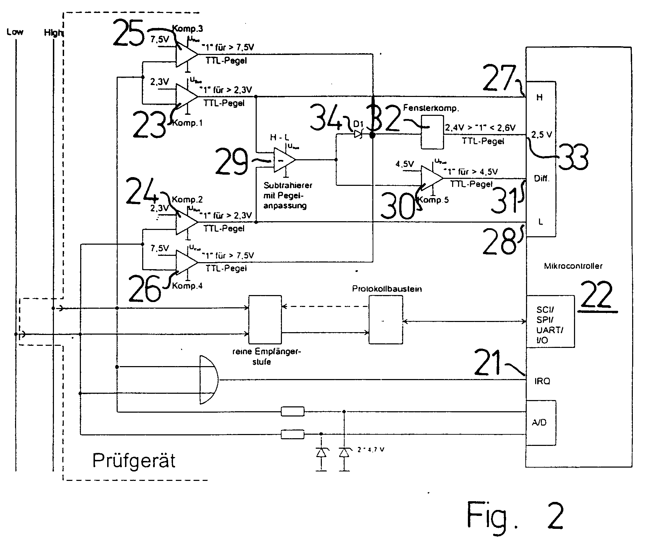

Figur 2 zeigt eine Schaltungsanordnung zur Durchführung des Verfahrens. Für die erfindungsgemäße Fehlerdiagnose muß in dem Ausführungsbeispiel eines CAN-Bus-Systems in einem Kraftfahrzeug die Batterie angeklemmt sein. Weiterhin müssen alle Steuergeräte aktiviert sein, wozu gegebenenfalls die Zündung eingeschaltet werden muß

Zunächst wird der Bus stimuliert, um einen definierten Ausgangszustand zu erreichen. Dadurch werden die Steuergeräte aktiviert. Die Stimulierung erfolgt über die Ansteuerung zweier Transistoren, die auf den beiden Busdrähten (Low und High) für eine gewisse Zeit ein dominantes Signal anlegen. Die Dauer der Stimulierzeit ist abhängig von Protokoll- und Transceiverbaustein.

Gestartet wird das Verfahren dann durch das erste dominante Bit einer Botschaft auf dem Bus, auf das der IRQ- (Interrupt) Eingang 21 des Mikrocontrollers 22 reagiert.

Zunächst wird jeder Pegel der beiden Drähte für sich betrachtet. Hierbei wird mittels Komparatoren (Komparator Komp. 1 mit Bezugsziffer 23 für H-Leitung, Komparator Komp. 2 mit Bezugsziffer 24 für L-Leitung) entschieden, ob der Signalpegel einer logischen "0" oder "1" entspricht. Dadurch werden die Buspegel auf TTL-Pegel normiert.

Überschreitet der Buspegel die Schwelle (7,5 V) der Komparatoren Komp. 3 mit Bezugsziffer 25 für die H-Leitung und Komp. 4 mit Bezugsziffer 26 für die L-Leitung, so wird zur Fehlerauswertung ein weiteres Signal mit dem logischen Wert "1" bereitgestellt. Liegt der Pegel unter 7,5 V, entspricht dies einer logischen "0".

Die beiden Ausgänge der Komparatoren Komp. 1 und Komp. 2 (23 und 24) werden direkt auf I/O-Ports 27 und 28 des Mikrocontrollers 22 gelegt.

Weiterhin werden die Ausgangssignale der Komparatoren Komp. 1 und Komp. 2 (23 und 24) auf die Eingänge eines Subtrahierers 29 gelegt, der ein Differenzsignal bildet. Dieses Differenzsignal wird anschließend in seiner Bandbreite von -5V bis +5V auf -2,5V bis +2,5V verringert und in den Bereich 0V bis +5V angehoben.

Das Ausgangssignal dieses Subtrahierers 29 wird durch den Komparator Komp. 5 (30) wieder in einen TTL-Pegel gewandelt, der ebenfalls auf einen I/O-Port 31 des Mikrocontrollers 22 gelegt wird.

Bei der Differenzbildung der Signale der Komparatoren 23 und 24 bilden sich zusätzlich zu den reinen TTL-Signalen noch "Halbsignale" in der Größenordnung von 2,5 V. Über einen Fensterkomparator 32 wird den Signalen dieser Größenordnung ein logischer Wert "1" zugeordnet, welcher auch direkt auf einen I/O-Port 33 des Mikrocontrollers 22 führt. Um Kurzschlüsse der H-Leitung oder L-Leitung gegen ein Potential größer als 7,5 V eindeutig detektieren zu können, muß der Fensterkomparator ausgeschaltet werden, was durch die Überlagerung der Signalpegel der Komparatoren 25 und 26 erfolgt. Die Diode 34 dient der Entkopplung von Subtrahierer 29 und den Ausgängen der Komparatoren 25 und 26.

Feldbus-Protokolle beginnen überlicherweise mit einem SOF (Start of Frame) oder SOM (Start od Message), was jeweils ein dominantes Bussignal ist. Auf die Startsequenz folgt in der Regel ein Identifier mit unterschiedlichen Pegelwechseln (dominant, rezessiv). Für die Messung reicht die dominante Startsequenz und ein darauf folgender Übergang in den rezessiven Zustand. Durch diese beiden Pegelzustände (dominant, rezessiv) und die daraus resultierenden Differenzsignale und 2,5 V-Signale entsteht eine Matrix, aufgrund der die meisten Fehler eindeutig erkannt werden können.

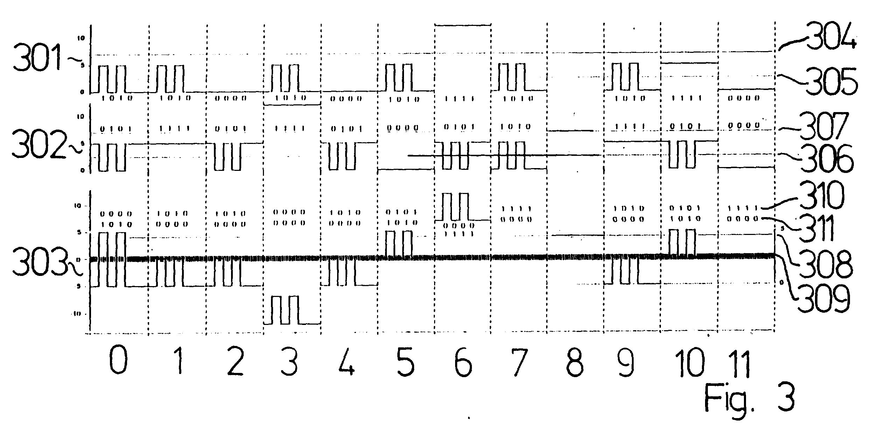

Figur 3 zeigt die Signalbetrachtung der einzelnen relevanten Busfehler, die auftreten können mit den jeweiligen zugehörigen TTL-Pegeln. Mit 301 ist der Signalverlauf auf der H-Leitung dargestellt, mit 302 der Signalverlauf auf der L-Leitung und mit 303 der Signalverlauf des Differerzsignales.

In x-Richtung sind die verschiedenen Situationen dargestellt. Mit 0 ist dabei der fehlerfreie Normalbetrieb bezeichnet, die Situationen 1 bis 11 entsprechend den Fehlern mit den entsprechenden Nummern nach Figur 1.

In 301 sind weiterhin die Schwellwerte der Komparatoren 25 und 23 eingezeichnet, die bei 7,5 V und bei 2,5 V liegen. Diese Schwellwerte sind mit 304 und 305 bezeichnet. Die im Zusammenhang mit 301 angegebenen Abfolgen der TTL-Pegel sind die Pegel, die sich an dem I/O-Port 27 des Mikrocontrollers 22 einstellen und entsprechen dem Ausgang des Komparators 23.

In 302 sind die Schwellwerte der Komparatoren 24 und 26 eingezeichnet, die ebenfalls bei 2,5 V und 7,5 V liegen. Diese Schwellwerte sind mit 306 und 307 bezeichnet. Die im Zusammenhang mit 302 angegebenen Abfolgen der TTL-Pegel sind die Pegel, die sich an dem I/O-Port 28 des Mikrocontrollers 22 einstellen und entsprechen dem Ausgang des Komparators 24.

In 303 ist der Schwellwert des Komparators 30 eingezeichnet, der bei 4 V liegt und mit 308 bezeichnet ist. Mit 309 ist der Spannungsbereich des Fensterkomparators 32 bezeichnet, der um 0,0 V liegt. Bei diesen beiden Schwellwerten zeigen sich Abweichungen in der Darstellung der Figur 3 gegenüber dem Schaltungsbeispiel der Figur 2. Dies liegt darin begründet, daß in dem Schaltungsbeispiel der Figur 2 das Ausgangssignal des Subtrahierers zunächst halbiert und anschließend um 2,5 V angehoben wurde. Figur 3 zeigt demgegenüber die Spannungsverhältnisse ohne diese "Umrechnung". Im Zusammenhang mit 303 sind jeweils zwei Abfolgen der TTL-Pegel angegeben. Die Abfolgen, die mit 310 bezeichnet sind, entsprechen dem Ausgang des Fensterkomparators 32 und liegen an dem I/O-Port 33 des Mikrocontrollers 22 an. Die Abfolgen, die mit 311 bezeichnet sind, entsprechen dem Ausgang des Komparators 30 und liegen an dem I/O-Port 31 des Mikrocontrollers 22 an.

Es ist zu sehen, daß sich bei den einzelnen Fehlern die entsprechenden Abfolgen der TTL-Pegel unterscheiden, so daß hierüber eine Unterscheidung der einzelnen Fehlerfälle möglich wird. Der Fehler mit der Nummer 8 (beide Busdrähte unterbrochen) kann nicht protokollunabhängig ermittelt werden. Für diesen Fehler ist die Berücksichtigung der Soll- und Ist-Konfiguration des Netzes notwendig oder es muß ein entsprechender Protokollbaustein vorgesehen werden, der am Bus "mithören" kann.

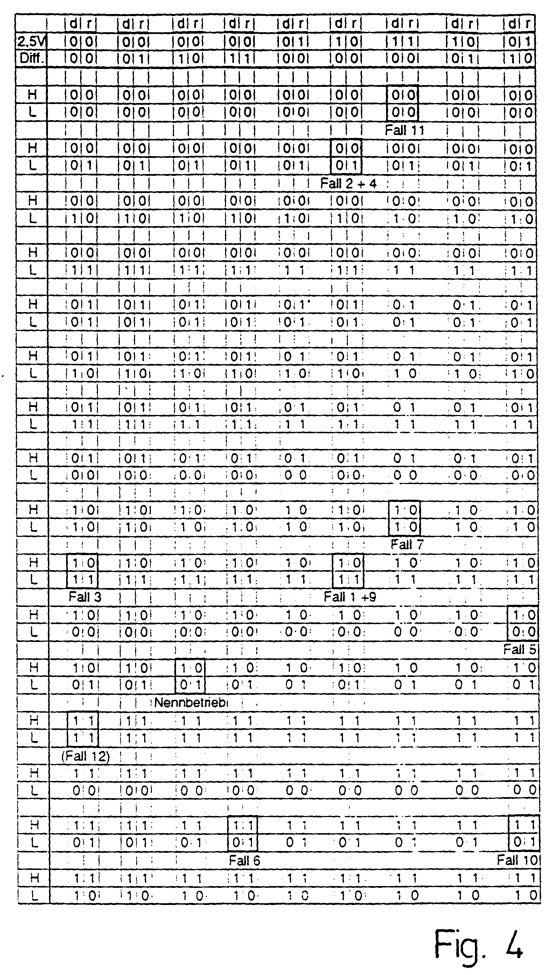

Figur 4 zeigt eine Matrix aller Kombinationen der TTL-Pegel. Das Signal am I/O-Port 33 des Mikrocontrollers 22 bildet die erste Zeile der oberste Doppelzeile der Matrix. Das Signal am I/O-Port 31 des Mikrocontrollers 22 bildet die zweite Zeile der obersten Doppelzeile der Matrix. Die weiteren Doppelzeilen der Matrix enthalten verschiedene Kombinationen der TTL-Pegel an den I/O-Ports 27 und 28. In jeder Doppelzeile sind dabei die TTL-Pegel sowohl für den dominanten als auch für den rezessiven Zustand aufgetragen. Die einzelnen Fehler entsprechen bestimmen Kombinationen der TTL-Pegel, die in der Figur 4 entsprechend markiert sind. Die Bezeichnung "Fall" mit der entsprechenden Nummer betrifft dabei den einzelnen Fehler. Eine Vorgehensweise, um aus den aufgenommenen TTL-Pegeln den entsprechenden Fehler herauszufinden, kann beispielsweise darin bestehen, zuerst auf der oberen Doppelzeile die zu den an den I/O-Ports 33 und 31 aufgenommen TTL-Pegeln entsprechende Spalte zu finden. Anschließend wird die zu den an den I/O-Ports 27 und 28 aufgenommenen TTL-Pegel entsprechenden Zeile ermittelt, wodurch der Fehler eingegrenzt werden kann. Es ist auch denkbar umgekehrt vorzugehen, d.h. zuerst die Zeile zu ermitteln und anschließend die zugehörige Spalte.

Ebenso kann dieser Matrix entnommen werden, daß mit weniger Meßgrößen der Fehler zwar eingegrenzt, nicht aber unbedingt genau und eindeutig festgestellt werden kann. Jedenfalls kann aber auch dabei der Normalbetrieb (Nennbetrieb) von den Fehlern unterschieden werden, da sowohl in derselben Spalte wie auch in derselben Zeile des Normalbetriebes kein Fehlerfall markiert ist. Diese Kombinationen der TTL-Pegel sind daher theoretische Kombinationen, die bei den genannten Fehlern nicht auftreten können. Werden also beispielsweise nur die Signale an den I/O-Ports 27 und 28 ausgewertet, kann beispielweise der Fehler 3 nicht von den Fehlern 1 und 9 unterschieden werden. Ebenso ist dann keine Unterscheidung der Fehler 6 und 10 möglich. Werden hingegen nur die I/O-Ports 31 und 33 ausgewertet, ist keine Unterscheidung der Fehler 1, 2, 4 und 9 sowie der Fehler 7 und 11 und auch der Fehler 5 und 10 möglich.

Hinsichtlich der Abfolge der TTL-Pegel wird der Normalbetrieb also wie jeder Fehlerfall auch behandelt.

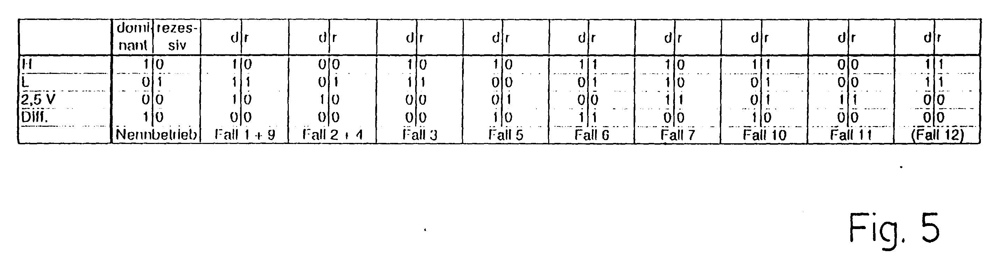

Figur 5 zeigt ein reduzierte Matrix, in der die Abfolge der TTL-Pegel der einzelnen Fehlerfälle sowie der Normalbetriebszustand angezeigt sind. Eine solche Liste kann beispielsweise in dem Mikrocontroller zur Auswertung als Vergleichsliste verwendet werden. Wenn weitere Fehlerfälle untersucht werden sollen, muß die Matirx nur entsprechend ergänzt werden. Mögliche Beispiele wären, daß die High- und Low-Leitung gegeneinander und nach U_{Batt} kurzgeschlossen sind. Dieser Fehlerfall ist in der Darstellung der Figur 4 sowie der Darstellung der Figur 5 schon als Fehler 12 vorgesehen. Ebenso könnte auch der Fehlerfall eines Masseversatzes ab 2,3 V ergänzt werden.

Es zeigt sich weiterhin, daß einzelne Fehler vorhanden sind, die die gleiche Abfolge der TTL-Pegel aufweisen, aber denen eine unterschiedliche Ursache zugrunde liegt. Dies betrifft die Paare der Fehler 1 und 9 sowie 2 und 4. Diese Fehler unterscheiden sich aber im zeitlichen auftreten. Die Fehler 1 und 2 (Kabelbruch einer Leitung) sind sogenannte lokale Fehler und treten nur beim Sender einer fehlerbetroffenen Station auf. Die Fehler 4 und 9 (Kurzschlußfehler) sind globale Fehler und liegen permanent am Bus an. Werden z.B. zehn aufeinander folgende Messungen vollzogen und es läßt sich jeweils der gleiche Fehlerzustand ermitteln, so liegt ein stationärer Busfehler vor und der Fehler kann somit dennoch eindeutig bestimmt werden.

Weiterhin ist es denkbar, mittels der A/D-Eingänge des Mikrocontrollers eine weitere ergänzende Überprüfung vorzunehmen.

In weiterer Ausgestaltung kann die Schaltungsanordnung beispielsweise in ein Prüfgerät integriert sein, das über ein integriertes Display oder eine Schnittstelle zu einem Drucker ein Prüfprotokoll mit einer Anzeige eines gefundenen Fehlers ausgibt. Gegebenenfalls kann dabei auch eine lokale Eingrenzung eines Kurzschlusses angezeigt werden, soweit diese näher lokalisiert worden ist.

Neben der Verbindung zur LOW- und HIGH-Leitung kann ein solches Prüfgerät eine Verbindung zur U_{Batt}-Leitung zur Stromversorgung aufweisen. Es ist hier aber auch denkbar, wahlweise eine Batterie als Energiequelle vorzusehen. Es muß dabei nur die Bedingung erfüllt sein, daß die Spannung der Batterie größer ist als V_{cc}.

Weiterhin muß dieses Prüfgerät eine Verbindung nach Masse aufweisen. Alle Steuergeräte, die an einen Feldbus angeschlossen sind, bewerten die Signale auf den Datenleitungen massebezogen bzw. benötigen ein Referenzpotential für Masse. Abhängig von den jeweilig eingesetzten Signaltreibern können bis zu einer bestimmten Bandbreite Masseversätze innerhalb eines Netzes toleriert werden. Für eine Erkennung von Leitungsfehlern innerhalb eines solchen Netzes wird auch in dem Prüfgerät das gleiche Referenzpotential für Masse benötigt wie für alle anderen Teilnehmer. Für eindeutige und reproduzierbare Messungen ist sogar die Absolutmasse des Bussystems notwendig, was dem Minus-Pol der Batterie im Kraftharzeug entspricht.

## Patentansprüche

1. Verfahren zur Überprüfung von Leitungsfehlern in einem Zweidraht-Bussystem durch Vergleich der Spannungspegel auf den beiden Drähten mit bestimmten Schwellwerten, wobei ein Vergleich mit den Schwellwerten im dominanten und im rezessiven Zustand erfolgt,
dadurch gekennzeichnet, daß die Spannungen auf den beiden Drähten mit jeweils einem Spannungspegel verglichen werden, der oberhalb des maximalen Spannungswertes auf den Drähten im dominanten und rezessiven Zustand im Normalbetrieb liegt (25, 26).

2. Verfahren nach Anspruch 1,
dadurch gekennzeichnet, daß die Spannungen auf den beiden Drähten mit jeweils einem Spannungspegel verglichen werden, der zwischen den beiden Spannungswerten auf den Drähten im dominanten und rezessiven Zustand im Normalbetrieb liegt (23, 24).

3. Verfahren nach einem der Ansprüche 1 oder 2,
dadurch gekennzeichnet, daß auch ein Vergleich der Spannungsdifferenz zwischen den Spannungen auf den beiden Drähten im dominanten und rezessiven Zustand mit vorgegebenen Schwellwerten erfolgt (29, 30, 32).

4. Verfahren nach Anspruch 3,
dadurch gekennzeichnet, daß die Spannungsdifferenz zwischen den Spannungen auf den beiden Drähten auf das Überschreiten eines ersten Spannungspegels überwacht wird (30) sowie darauf, ob der Spannungspegel innerhalb eines durch einen zweiten und einen dritten Spannungspegel vorgegebenen Fensters liegt, wobei der erste Spannungspegel über dem zweiten und dem dritten Spannungspegel liegt (32).

5. Schaltungsanordnung zur Durchführung eines der vorgenannten Verfahren,
dadurch gekennzeichnet, daß ein Eingang eines ersten Komparators (23) mit dem einen Draht verbunden ist, daß ein Eingang eines zweiten Komparators (24) mit dem anderen Draht verbunden ist und daß die anderen Eingänge des ersten und des zweiten Komparators (23, 24) jeweils mit einer Spannung beaufschlagt werden, die zwischen den beiden Spannungswerten auf den Drähten im dominanten und rezessiven Zustand im Normalbetrieb liegt,
daß weiterhin ein Eingang eines dritten Komparators (25) mit dem einen Draht verbunden ist, daß ein Eingang eines vierten Komparators (26) mit dem anderen Draht verbunden ist und daß die anderen Eingänge des dritten und des vierten Komparators (25, 26) jeweils mit einer Spannung beaufschlagt werden, die oberhalb des maximalen Spannungswertes auf den Drähten im dominanten und rezessiven Zustand im Normalbetrieb liegt,
daß die Ausgänge des ersten und des zweiten Komparators (23, 24) einem Subtrahierer (29) zugeführt werden, wobei eine Spannungsanpassung des Pegels des Ausgangssignales erfolgt,
wobei das Ausgangssignal des Subtrahierers (29) dem Eingang eines fünften Komparators (30) zugeführt wird und
wobei das Ausgangssignal des Subtrahierers (29) weiterhin über eine Diode (34) dem Eingang eines Fensterkomparators (32) zugeführt wird, wobei weiterhin die Ausgänge des dritten und des vierten Komparators (25, 26) mit dem Eingang des Fensterkomparators (32) verbunden sind.

6. Schaltungsanordnung nach Anspruch 5,
dadurch gekennzeichnet, daß die Ausgänge des ersten, des zweiten und des fünften Komparators (23, 24, 30) sowie des Fensterkomparators (32) ausgewertet werden, um auf den Zustand der Drähte zu schließen.
